# EUROPEAN PATENT APPLICATION

(11) **EP 4 611 485 A1**
(43) Date of publication of application: **03.09.2025**
(21) Application number: 22963158.5
(22) Date of filing: 28.10.2022
(51) Int. Cl.: H05B 33/02, H01S 5/0233

(54) **INTEGRATED APPARATUS AND MANUFACTURING METHOD THEREFOR, AND INTEGRATED CIRCUIT, DETECTION APPARATUS AND TERMINAL**

(71) Applicant: Shenzhen Yinwang Intelligent Technologies Co., Ltd., Shenzhen, Guangdong 518129 (CN)
(72) Inventor: ZHANG, Yi, Shenzhen, Guangdong 518129 (CN); CAI, Zhonghua, Shenzhen, Guangdong 518129 (CN); ZHONG, Guowei, Shenzhen, Guangdong 518129 (CN)
(74) Representative: Körber, Martin Hans
(86) International application number: PCT/CN2022/128285
(87) International publication number: WO 2024/087176

(57) **Abstract**

This application relates to the field of electronic technologies, and provides an integrated apparatus, a manufacturing method, an integrated circuit, a detection apparatus, and a terminal, to reduce parasitics introduced in an integrated apparatus, so as to improve effective energy conversion efficiency of the integrated apparatus. The detection apparatus may be a lidar. The integrated apparatus includes: a laser, including an anode, a cathode, and a first substrate; and a capacitor, including a second substrate, an insulator, and a comb-shaped first metal layer, where the insulator is attached to the first metal layer, and the first substrate is in contact with the second substrate, so that a distance between the laser and the capacitor is reduced in a three-dimensional layout manner. The anode is embedded in the first substrate and is connected to the second substrate, to implement interconnection between the laser and the capacitor. **In** this way, no extra interconnection trace needs to be disposed between the laser and the capacitor, so that parasitics introduced in the integrated apparatus are greatly reduced.

## Description

### TECHNICAL FIELD

This application relates to the field of electronic technologies, and in particular, to an integrated apparatus, a manufacturing method, an integrated circuit, a detection apparatus, and a terminal.

### BACKGROUND

A lidar (light detection and ranging, LiDAR) is an optical measurement device whose working principle is to emit a laser signal to an object, receive a target echo signal reflected by the object, and then compare the target echo signal with the laser signal, to obtain related parameters such as a location and a distance of the object. The lidar can accurately scan a surrounding object to form a high-definition image, helping quickly recognize the surrounding object and make decisions. Currently, the lidar has been widely used in scenarios such as intelligent vehicles, smart transportation, three-dimensional city mapping, and atmospheric environment monitoring.

The lidar has a plurality of components. Currently, a layout of the components on a printed circuit board (printed circuit board, PCB) introduces great extra parasitics. For example, a trace between the components on the PCB introduces an extra parasitic resistance, an extra parasitic inductance, and the like in a circuit. In addition, a longer trace leads to a larger parameter value of introduced parasitics. As a result, in a working process of the lidar, more energy is consumed by the parasitics, and effective energy conversion efficiency used for laser working is reduced.

### SUMMARY

This application provides an integrated apparatus, a manufacturing method, an integrated circuit, a detection apparatus, and a terminal, to reduce parasitics introduced in an integrated apparatus, so as to improve effective energy conversion efficiency of the integrated apparatus.

According to a first aspect, this application provides an integrated apparatus. The integrated apparatus includes: a laser (for example, the laser may be a laser diode that can emit a wavelength of 905 nanometers) including an anode, a cathode, and a first substrate; and a capacitor including a second substrate, an insulator, and a comb-shaped first metal layer, where the insulator is attached to the first metal layer, and a shape of the insulator may be a "bow" shape. The first substrate is in contact with the second substrate (that is, no other medium or device exists between the first substrate and the second substrate, and the first substrate is in direct contact with the second substrate), and the anode is embedded in the first substrate and is connected to the second substrate (that is, the anode is connected to the second substrate after extending in the first substrate and penetrating the first substrate).

In the foregoing technical solution, the first substrate in the laser and the second substrate of the capacitor are stacked and in contact, so that a distance between the laser and the capacitor can be reduced in a three-dimensional layout manner. In addition, the anode of the laser is embedded in the first substrate and is connected to the second substrate, to implement interconnection between the laser and the capacitor. In this way, no extra interconnection trace needs to be disposed between the laser and the capacitor, so that parasitics (for example, a parasitic inductance and a parasitic resistance) introduced in a structure of the integrated apparatus are greatly reduced, and effective energy conversion efficiency of the integrated apparatus is improved. The integrated apparatus obtained in the foregoing manufacturing method may reduce an interconnection length between the laser and the capacitor from a 100-micron (µm) level to a µm level. In addition, the comb-shaped first metal layer can further increase a specific surface area of the capacitor, to facilitate heat dissipation and reduce a heat loss.

In a possible implementation of the first aspect, the first substrate and the second substrate are integrally formed. That the first substrate and the second substrate are integrally formed herein may mean that the first substrate and the second substrate are two parts of a same substrate formed in one process. In a possible example, the first substrate and the second substrate may be two parts, namely, an upper part and a lower part, of a same wafer. The first substrate and the second substrate are integrally formed, so that one wafer can be saved, and process materials and process costs required when two wafers are bonded (for example, bonding is implemented through back-end-of-line grinding and bonding) can also be saved.

In a possible implementation of the first aspect, a material of the first substrate is the same as or different from a material of the second substrate. In a possible example, the materials of the first substrate and the second substrate are the same. For example, both the materials of the first substrate and the second substrate may be aluminum gallium arsenide AlGaAs and/or gallium arsenide GaAs. In another possible example, the materials of the first substrate and the second substrate are different. For example, the material of the first substrate may be AlGaAs, and the material of the second substrate may be GaAs; or the material of the first substrate may be GaAs, and the material of the second substrate may be AlGaAs. In the foregoing possible implementation, because a lattice constant of the AlGaAs is different from a lattice constant of the GaAs layer, and the lattice constant of the AlGaAs is less than the lattice constant of the GaAs layer, the AlGaAs and the GaAs undergo compressive strain in x and y directions (namely, two directions that are parallel to the substrate and perpendicular to each other), and undergo tension in a z direction (namely, a direction perpendicular to the substrate). In this way, electrons in the AlGaAs and the GaAs have a large mobility, and a corresponding resistivity is low, so that parasitic resistances of the integrated apparatus are greatly reduced, and performance of the integrated apparatus is improved. In addition, because conductivity of the AlGaAs is good, a resistance of the AlGaAs can be further reduced by using the AlGaAs layer, to further improve performance of the integrated apparatus.

In a possible implementation of the first aspect, the cathode is located on a side that is of the first substrate and that is away from the second substrate. In an example, the first substrate is located above the second substrate, and the cathode is disposed on an upper surface of the first substrate. In addition, in an example, the cathode may include a plurality of sub-electrodes, and the plurality of sub-electrodes may be dispersedly distributed on the side that is of the first substrate and that is away from the second substrate.

In a possible implementation of the first aspect, the second substrate is a low-resistivity (or referred to as heavy doping) substrate. In this case, the capacitor is of an MIS structure and includes the second substrate, the insulator, and the first metal layer.

In a possible implementation of the first aspect, the second substrate is a high-resistivity substrate, the capacitor further includes a second metal layer, the second metal layer is located between the second substrate and the insulator, and the anode is embedded in the second substrate and is connected to the second metal layer. In other words, the second substrate may be a lightly doped or non-doped substrate. In this case, the capacitor C is of an MIM structure and includes the second substrate, the second metal layer, the insulator, and the first metal layer.

In a possible implementation of the first aspect, at least two comb teeth in the first metal layer have a same height or different heights. A height of each comb tooth herein may be a height at which the comb tooth extends into the second substrate. For example, heights of all comb teeth in the first metal layer are the same; or heights of some comb teeth in all comb teeth in the first metal layer are different from heights of other comb teeth.

In a possible implementation of the first aspect, a Maximum height of a comb tooth in the first metal layer is less than a thickness of the second substrate. In other words, the comb tooth in the first metal layer does not penetrate a side surface that is of the second substrate and that is close to the first substrate.

According to a second aspect, this application provides a manufacturing method for an integrated apparatus. The integrated apparatus includes a laser and a capacitor, the laser (for example, the laser may be a laser diode that can emit a wavelength of 905 nanometers) includes an anode, a cathode, and a first substrate, and the capacitor includes a second substrate, an insulator, and a comb-shaped first metal layer. The method includes: forming a first substrate and a second substrate, where the first substrate is in contact with the second substrate (that is, no other medium or device exists between the first substrate and the second substrate, and the first substrate is in direct contact with the second substrate); forming, on the first substrate, the cathode and the anode that is embedded in the first substrate, where the anode is embedded in the first substrate and is connected to the second substrate (that is, the anode is connected to the second substrate after extending in the first substrate and penetrating the first substrate); forming a plurality of grooves on a side that is of the second substrate and that is away from the first substrate, where a depth of the groove is less than a thickness of the second substrate; and forming the insulator on a surface that is of the second substrate and that has the plurality of grooves, and forming the comb-shaped first metal layer on the insulator, where a thickness of the insulator is less than one half of a radial width of the groove.

In a possible implementation of the second aspect, the first substrate and the second substrate are integrally formed. That the first substrate and the second substrate are integrally formed herein may mean that the first substrate and the second substrate are two parts of a same substrate formed in one process. In a possible example, the first substrate and the second substrate may be two parts, namely, an upper part and a lower part, of a same wafer.

In a possible implementation of the second aspect, a material of the first substrate is the same as or different from a material of the second substrate. In a possible example, the materials of the first substrate and the second substrate are the same. In another possible example, the materials of the first substrate and the second substrate are different.

In a possible implementation of the second aspect, the cathode is located on a side that is of the first substrate and that is away from the second substrate, and the forming, on the first substrate, the cathode and the anode that is embedded in the first substrate includes: forming the cathode on the side that is of the first substrate and that is away from the second substrate, and forming the anode that is embedded in the first substrate and that is connected to the second substrate.

In a possible implementation of the second aspect, the second substrate is a high-resistivity substrate, the capacitor further includes a second metal layer, the second metal layer is located between the second substrate and the insulator, and the anode is embedded in the second substrate and is connected to the second metal layer; and the forming the insulator on a surface that is of the second substrate and that has the plurality of grooves includes: forming the second metal layer on the surface that is of the second substrate and that has the plurality of grooves; and forming the insulator on the second metal layer, where a sum of a thickness of the second metal layer and the thickness of the insulator is less than the half of the radial width of the groove.

In a possible implementation of the second aspect, at least two comb teeth in the first metal layer have a same height or different heights. For example, heights of all comb teeth in the first metal layer are the same; or heights of some comb teeth in all comb teeth in the first metal layer are different from heights of other comb teeth.

In a possible implementation of the second aspect, a height of a comb tooth in the first metal layer is less than a thickness of the second substrate. In other words, the comb tooth in the first metal layer does not penetrate a side surface that is of the second substrate and that is close to the first substrate.

According to a third aspect, this application provides an integrated circuit. The integrated circuit includes the integrated apparatus according to the first aspect or any one of the possible implementations of the first aspect and a switch device including a first electrode and a second electrode that are located on a same side. The integrated apparatus is disposed on the switch device, the cathode of the laser in the integrated apparatus is connected to the first electrode through a trace, and the first metal layer of the capacitor in the integrated apparatus is in contact with the second electrode.

According to a fourth aspect, this application provides a detection apparatus. The detection apparatus includes the integrated apparatus provided in the first aspect or any one of the possible implementations of the first aspect, or includes the integrated circuit provided in the second aspect.

According to a fifth aspect, this application provides a terminal. The terminal includes the integrated apparatus provided in the first aspect or any one of the possible implementations of the first aspect, or includes the integrated circuit provided in the second aspect. Optionally, the terminal is a vehicle.

It may be understood that, for beneficial effect that can be achieved by any one of the manufacturing method for the integrated apparatus, the integrated circuit, the detection apparatus, and the terminal, refer to the beneficial effect of the integrated apparatus. Details are not described herein again.

### BRIEF DESCRIPTION OF DRAWINGS

FIG. 1 is a diagram of an application scenario of a lidar according to an embodiment of this application;
FIG. 2 is a diagram of an internal architecture of a lidar according to an embodiment of this application;
FIG. 3A is a diagram of a structure of a transmitting module according to an embodiment of this application;
FIG. 3B is a diagram of a structure of another transmitting module according to an embodiment of this application;
FIG. 4 is a diagram of a layout manner of components in a transmitting module;
FIG. 5 is a diagram of a structure of an integrated apparatus according to an embodiment of this application;
FIG. 6 is a diagram of a structure of another integrated apparatus according to an embodiment of this application;
FIG. 7 is a diagram of a structure of a capacitor according to an embodiment of this application;
FIG. 8 is a diagram of a structure of another integrated apparatus according to an embodiment of this application;
FIG. 9 is a diagram of a structure of an integrated circuit according to an embodiment of this application;
FIG. 10 is a schematic flowchart of a manufacturing method for an integrated apparatus according to an embodiment of this application;
FIG. 11 is a cross-sectional view of an integrated apparatus in a manufacturing process according to an embodiment of this application; and
FIG. 12 is a schematic flowchart of another manufacturing method for an integrated apparatus according to an embodiment of this application.

### DESCRIPTION OF EMBODIMENTS

The following clearly and completely describes the technical solutions in embodiments of this application with reference to the accompanying drawings in embodiments of this application.

A "connection" in embodiments of this application may be an electrical connection, and a connection between two electrical elements may be a direct or indirect connection between the two electrical elements. For example, a connection between A and B may be a direct connection between A and B, or may be an indirect connection between A and B through one or more other electrical elements. For example, that A is connected to B may alternatively be that A is directly connected to C, C is directly connected to B, and A is connected to B through C. In some scenarios, the "connection" may also be understood as coupling, for example, electromagnetic coupling between two inductors. In conclusion, the connection between A and B enables transmission of electric energy between A and B.

A name of an end of an electronic component in embodiments of this application is merely an example description, and may be understood as a connection end or a connection point, and is connected to another circuit component. In another example, there may be another end name, connection end name, or connection point name. For example, in some scenarios, the end may also be referred to as a communication end, an information transmission end, a terminal, a connection end, a communication connection end, an information connection end, a connection point, a communication connection point, an information connection point, or an electrode.

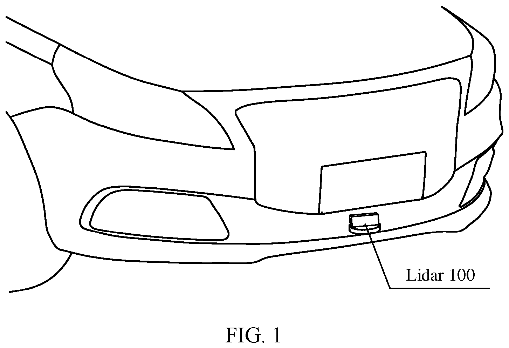

An embodiment of this application provides a circuit structure. In an application scenario, the circuit structure may be used in a detection apparatus like a lidar. FIG. 1 is a diagram of an example of an application scenario of a lidar according to an embodiment of this application. In this example, a lidar 100 is mounted on a vehicle, and therefore is also referred to as a vehicle-mounted lidar. In addition to the vehicle-mounted lidar, the lidar further includes a shipborne lidar mounted on a ship, an airborne lidar mounted on a machine, or the like. In a possible example, as shown in FIG. 1, the lidar 100 may be mounted, for example, at a head location of the vehicle. In this way, in a travel process of the vehicle, the lidar 100 may send a laser signal. After being irradiated to an object in an ambient environment, the laser signal is reflected by the object, and a reflected target echo signal may be received by the lidar 100, so that the lidar 100 obtains ambient environment information of the vehicle through detection based on the target echo signal, to assist or control a driving function of the vehicle by using the environment information, for example, including but not limited to autonomous driving or assisted driving.

The lidar 100 may be one of a mechanical lidar, a liquid lidar, a pure solid-state lidar, or a hybrid solid-state lidar (also referred to as a semi-solid-state lidar), or may be another type of lidar. This is not specifically limited in embodiments of this application. In addition, a housing of the lidar 100 may be a cuboid shown in FIG. 1, or may be a cube, a cylinder, an annular body, an amorphous body, or the like. A shape of the housing of the detection apparatus is not specifically limited in embodiments of this application.

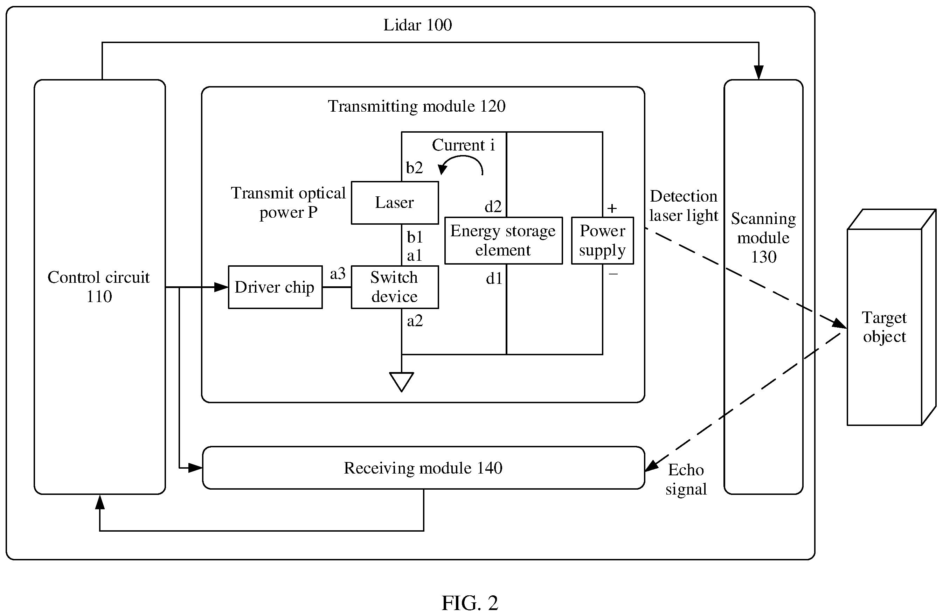

Further, FIG. 2 is a diagram of an internal architecture of a lidar according to an embodiment of this application. As shown in FIG. 2, a lidar 100 may include a control circuit 110, a transmitting module 120, a scanning module 130, and a receiving module 140. The transmitting module 120 and the receiving module 140 include optical elements such as one or more of a lens, a light filter, a polarizer, a reflector, a beam splitter, a prism, a window plate, and a scattering sheet. A specific quantity and types of the included optical elements are related to optical designs of the transmitting module 120 and the receiving module 140 in the lidar 100. This is not specifically limited in embodiments of this application. The transmitting module 120 may include at least one optical laser, and the at least one optical laser may be connected in series or in parallel, and is configured to emit detection laser light under control of the control circuit 110. The scanning module 130 may include one or more of a multi-faceted rotating mirror, a swing mirror, a micro-electro-mechanical system (micro-electro-mechanical system, MEMS) scanning mirror, or a prism, and is configured to change, under control of the control circuit 110, a scanning angle of the detection laser light emitted by the transmitting module 120, so that the detection laser light can perform traversal scanning on a target object in an environment. For different types of lidars, implementations of the scanning module 130 are different, and there may alternatively be no scanning module in some types of lidars, for example, a phased-array radar in a solid-state lidar. The detection laser light emitted by the transmitting module 120 is further reflected by the target object in the environment, to generate an echo signal. The receiving module 140 may be configured to: under control of the control circuit 110, receive the echo signal corresponding to the detection laser light, convert the echo signal into an electrical signal, and send the electrical signal to the control circuit 110. The control circuit 110 determines a feature of the target object based on the electrical signal. It may be understood that the lidar 100 may alternatively include more or fewer components than those shown in FIG. 2. This is not specifically limited in embodiments of this application.

The control circuit 110 may include at least one integrated circuit chip. For example, the control circuit 110 may include at least one processor, and when the control circuit 110 includes a plurality of processors, types of the included processors may be the same or different. The processor is an element or a circuit having a processing capability, for example, including one or more of the following types: a general-purpose processor, a field programmable gate array (field programmable gate array, FPGA), an application-specific integrated circuit (application-specific integrated circuit, ASIC), a neural-network processing unit (neural-network processing unit, NPU), a graphics processing unit (graphics processing unit, GPU), an application processor (application processor, AP), a modem processor, an image signal processor (image signal processor, ISP), a video codec, a digital signal processor (digital signal processor, DSP), a baseband processor, a network processor (network processor, NP), a digital signal processing circuit (digital signal processor, DSP), a micro controller unit (micro controller unit, MCU), a programmable controller (programmable logic device, PLD) or another programmable logic device, a discrete gate or a transistor logic device, a discrete hardware component, or another integrated chip. The general-purpose processor includes, for example, a central processing unit (central processing unit, CPU). In addition, all or some integrated circuit chips included in the control circuit 110 may be integrated together and presented in a form of a system on chip (system on chip, SoC).

In a possible implementation, still refer to FIG. 2. The transmitting module 120 may include a driver chip, a switch device, a laser, an energy storage element, and a power supply. An input end of the driver chip is connected to the control circuit 110, an output end of the driver chip is connected to a third end (a3) of the switch device, a first end (a1) of the switch device is connected to a first end (b1) of the laser, a second end (b2) of the laser is separately connected to a second end (d2) of the energy storage element and a positive electrode of the power supply, and a second end (a2) of the switch device is separately connected to a first end (d1) of the energy storage element and a negative electrode of the power supply and then grounded (namely, a device marked with an inverted triangle "V" in FIG. 2, where grounding may mean that a component is connected to the ground through a conductor, or may mean that a grounding circuit is disposed and the component is connected to the grounding circuit, and this is not specifically limited). The driver chip may be a chip that can drive the switch device to be turned on or turned off, and may be usually implemented by integrating a plurality of levels of drive devices into one electronic chip. The switch device may be any device that can implement turn-on and turn-off, for example, a field-effect transistor (field-effect transistor, FET). The FET may be an N-channel metal-oxide-semiconductor field-effect transistor (N-channel metal-oxide-semiconductor field-effect transistor, NMOSFET), or may be a P-channel metal-oxide-semiconductor field-effect transistor (P-channel metal-oxide-semiconductor field-effect transistor, PMOSFET). This is not specifically limited. The laser may be a single laser, or may be a laser chain formed by a plurality of lasers connected in series, or may be a laser ring formed by a plurality of lasers connected in parallel, or may be a laser array formed by a plurality of lasers connected in series and in parallel. A type of the laser may be an edge emitting laser (edge emitting laser, EEL), a surface emitting laser (surface emitting laser, SEL), or the like. The energy storage element may be an element like a capacitor (for example, a silicon capacitor) or an inductor that can store electric energy.

In the foregoing implementation, in a process of controlling the transmitting module 120 to work, the control circuit 110 may send periodically repeated pulse control signals, for example, send, in an earlier time period of a periodicity, a first control signal used to turn off the switch device, and send, in a later time period of the periodicity, a second control signal used to turn on the switch device. In this way, in the earlier time period of the periodicity, the driver chip drives, based on the first control signal, the first end a1 and the second end a2 of the switch device to be disconnected. In this case, electric energy output by the power supply is provided to the energy storage element but is not provided to the laser. Therefore, the energy storage element can store the electric energy output by the power supply. Then, in the later time period of the periodicity, the driver chip drives, based on the second control signal, the first end a1 and the second end a2 of the switch device to be connected. In this case, the energy storage element that has stored energy in the earlier time period starts to discharge, and the discharge enables a transient current i to be formed in a loop formed by the laser, the switch device, and the energy storage element. The transient current i drives the laser to emit the detection laser light. A larger value of the transient current i indicates a larger transmit optical power P of the laser. In this way, the laser in the transmitting module 120 also periodically emits light under the periodically repeated pulse control signals of the control circuit 110.

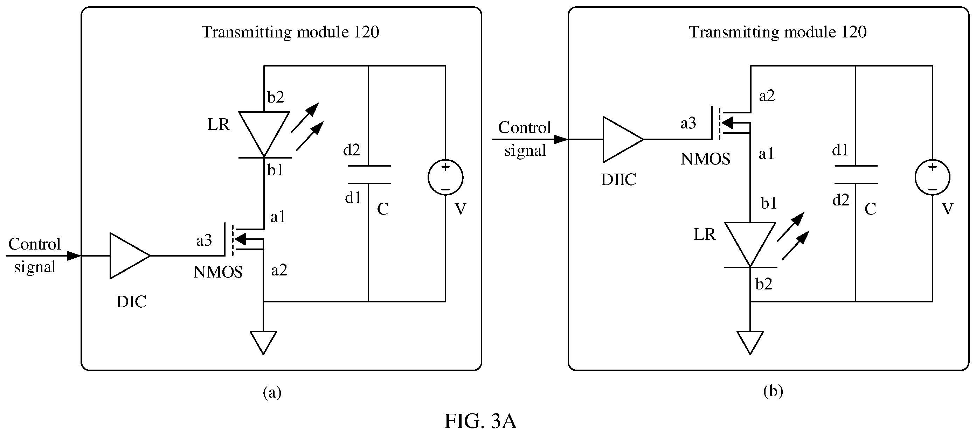

In this embodiment of this application, there are a plurality of possible connection manners for the components in the transmitting module 120. For example, it is assumed that the switch device is an NMOS transistor, the driver chip is a driver integrated circuit chip (driver integrated circuit chip, DIC), the laser is a single laser (laser, LR), and the energy storage element is a capacitor C. In this case, FIG. 3A is a diagram of an example of a component connection structure of the transmitting module according to an embodiment of this application.

In an example, as shown in (a) in FIG. 3A, the first end a1 of the switch device is a drain of the NMOS transistor, the second end a2 of the switch device is a source of the NMOS transistor, the third end a3 of the switch device is a gate of the NMOS transistor, the first end b1 of the laser is a cathode of the laser LR, and the second end b2 of the laser is an anode of the laser LR. A specific connection manner is as follows: The output end of the driver chip DIC is connected to the gate a3 of the NMOS transistor, the drain a1 of the NMOS transistor is connected to the cathode b1 of the laser LR, the anode b2 of the laser LR is separately connected to the second end d2 of the capacitor C and the positive electrode of the power supply, and the source a2 of the NMOS transistor is separately connected to the first end d1 of the capacitor C and the negative electrode of the power supply and then grounded. According to the circuit connection structure, in the process of controlling the transmitting module 120 to work, the control circuit 110 may output a low-level first control signal to the driver chip DIC in an earlier time period of a periodicity, and output a high-level second control signal to the driver chip DIC in a later time period of the periodicity. In this way, in the earlier time period of the periodicity, the driver chip DIC drives, based on a low level, the source a2 and the drain a1 of the NMOSFET to be disconnected. In this case, the electric energy output by the power supply V cannot be provided to the laser LR, but can be provided to the capacitor C, to charge the capacitor C. In this case, because a link on which the laser LR is located is disconnected, the laser LR does not emit the detection laser light. Then, in the later time period of the periodicity, the driver chip DIC drives, based on a high level, the source a2 and the drain a1 of the NMOSFET to be connected. In this case, the link on which the laser LR is located is connected, and the capacitor C may discharge to the laser LR. Therefore, the laser LR may emit the detection laser light.

In another example, as shown in (b) in FIG. 3A, the first end a1 of the switch device is a source of the NMOS transistor, the second end a2 of the switch device is a drain of the NMOS transistor, the third end a3 of the switch device is a gate of the NMOS transistor, the first end b1 of the laser is an anode of the laser LR, and the second end b2 of the laser is a cathode of the laser LR. A specific connection manner is as follows: The output end of the driver chip DIC is connected to the gate a3 of the NMOS transistor, the source a1 of the NMOS transistor is connected to the cathode b1 of the laser LR, the anode b2 of the laser LR is separately connected to the second end d2 of the capacitor C and the negative electrode of the power supply and then grounded, and the drain a2 of the NMOS transistor is separately connected to the first end d1 of the capacitor C and the positive electrode of the power supply. A working process of the circuit connection structure shown in (b) in FIG. 3A is similar to that of the circuit connection structure shown in (a) in FIG. 3A. A reason is that the capacitor C is actually formed by two conductors that are insulated from each other and that are close to each other. In the circuit connection structure shown in (a) in FIG. 3A, when the capacitor C is charged in the earlier time period, a conductor forming the second end d2 of the capacitor is positive and a conductor forming the first end d1 of the capacitor is negative. Therefore, during the discharge in the later time period, electric energy output by the conductor forming the second end d2 of the capacitor C sequentially flows through the anode b2 of the laser LR, the cathode b1 of the laser LR, the drain a1 of the NMOS transistor, and the source a2 of the NMOS transistor, and then flows back to the conductor forming the first end d1 of the capacitor C, to drive the laser LR to emit light. Similarly, in the circuit connection structure shown in (b) in FIG. 3A, when the capacitor C is charged in the earlier time period, the conductor forming the first end d1 of the capacitor is positive and the conductor forming the second end d2 of the capacitor is negative. Therefore, during the discharge in the later time period, electric energy output by the conductor forming the first end d1 of the capacitor C sequentially flows through the drain a2 of the NMOS transistor, the source a1 of the NMOS transistor, the anode b1 of the laser LR, and the cathode b2 of the laser LR, and then flows back to the conductor forming the second end d2 of the capacitor C, to drive the laser LR to emit light.

In the foregoing content, merely two possible component connection manners of the transmitting module 120 are described as examples. In an actual operation, some variations may be made to the connection manners shown in the foregoing examples. The connection manners fall within the protection scope of embodiments of this application provided that a transmit function of the transmitting module 120 is not affected. This is not specifically limited in embodiments of this application.

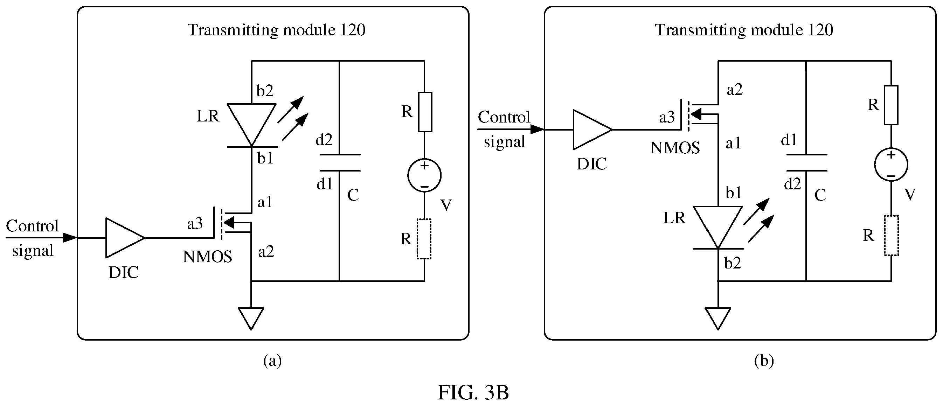

In addition, some variations may be made to the components included in the transmitting module 120. For example, some components in the transmitting module 120 are modified to other components that can implement a same function. For example, the NMOS transistor is replaced with a diode or a PMOS transistor. When the NMOS transistor is replaced with the PMOS transistor, the PMOS transistor is turned on at the low level and turned off at the high level. Therefore, if the control circuit still sends the low-level first control signal in an earlier time period of a periodicity and sends the high-level second control signal in a later time period of the periodicity, the laser emits the detection laser light in the earlier time period of the periodicity, and does not emit the detection laser light in the later time period of the periodicity. For another example, some components may be added to or deleted from the transmitting module 120. In a possible example, as shown in (a) in FIG. 3B or (b) in FIG. 3B, the transmitting module 120 may further include a resistance element R, and the resistance element R is connected in series to the power supply V. For example, in an example, as shown in (a) in FIG. 3B, a first end of the resistance element R is connected to the positive electrode of the power supply V, and a second end of the resistance element R is connected to the anode b2 of the laser LR and the second end d2 of the capacitor C; or a first end of the resistance element R is connected to the negative electrode of the power supply V, and a second end of the resistance element R is connected to the source a2 of the NMOS transistor and the first end d1 of the capacitor C and then grounded. Alternatively, in another example, as shown in (b) in FIG. 3B, a first end of the resistance element R is connected to the positive electrode of the power supply V, and a second end of the resistance element R is connected to the drain a2 of the NMOS transistor and the first end d1 of the capacitor C; or a first end of the resistance element R is connected to the negative electrode of the power supply V, and a second end of the resistance element R is connected to the cathode b2 of the laser LR and the second end d2 of the capacitor C and then grounded. For a working process of the circuit connection structure, refer to that of the circuit connection structure shown in (a) in FIG. A or (b) in FIG. 3A. A difference lies in that, in an earlier time period of a periodicity, a part of electric energy output by the power supply V is consumed by the resistance element R, and the other part is provided to the capacitor C. In other words, after charging is completed, electric energy stored by the capacitor C is less than that in the structure shown in (a) in FIG. 3A. In a later time period of the periodicity, the capacitor C, the resistor R, and the laser LR form a loop. Therefore, a current on the loop is less than that on a loop formed by only the capacitor C and the laser LR shown in (a) in FIG. 3A, and intensity of the detection laser light emitted by the laser LR is weaker than that in the structure shown in (a) in FIG. 3A. In addition, if the intensity of the detection laser light needs to be flexibly adjusted, the resistance element R may be further set to have a variable resistance. When detection laser light with weak intensity needs to be emitted, a resistance value of the variable resistance is set to a larger value. When detection laser light with strong intensity needs to be emitted, a resistance value of the variable resistance is set to a smaller value.

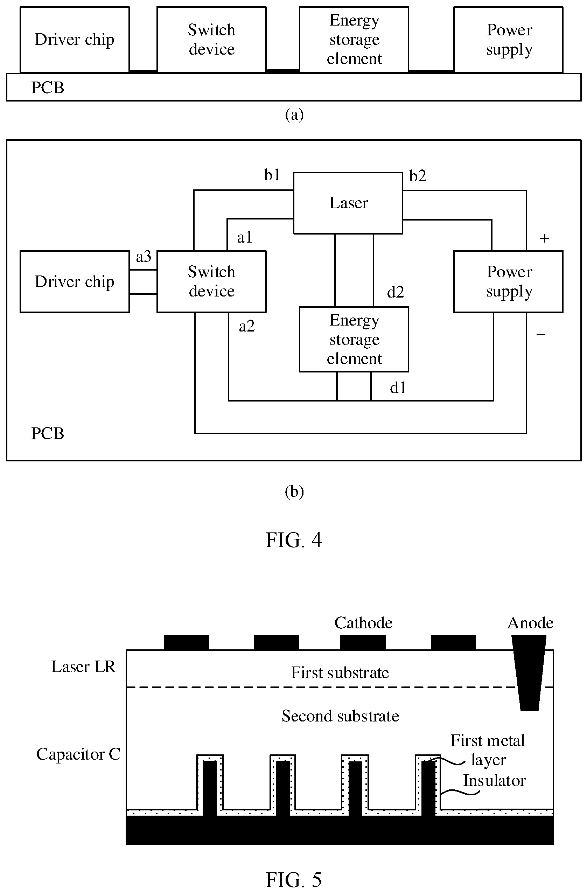

Further, with reference to FIG. 2, FIG. 4 is a diagram of a component layout manner of the transmitting module. (a) in FIG. 4 is a main view of the component layout manner of the transmitting module, and (b) in FIG. 4 is a top view of the component layout manner of the transmitting module. As shown in (a) in FIG. 4 and (b) in FIG. 4, a PCB board is disposed in the layout manner. After the driver chip, the switch device, the laser, the energy storage element, and the power supply in the transmitting module 120 are separately packaged into packages, the packages are arranged on the PCB board in a planar manner, and the packages are connected to each other through a trace on the PCB. In a partial circuit structure, a quantity of packages included in the circuit structure and the trace introduce parasitics (for example, a parasitic resistance and a parasitic inductance) to the circuit structure, and the introduced parasitics are connected in series to the link on which the laser is located. It is assumed that the parasitic resistance is R, the parasitic inductance is L, an output power of the power supply is Pₒᵤₜ, and photoelectric conversion efficiency is η. It can be learned from the working principle of the transmitting module described above that the transient current i is formed by discharging of the energy storage element after the switch device is turned on. As the parasitic inductance L and the parasitic resistance R that are connected in series in the link on which the laser is located decrease, the transient current i correspondingly increases, so that the transmit optical power P of the laser also increases. In other words, the transmit optical power P of the laser is approximately proportional to the transient current i. In addition, the transient current i is approximately proportional to 1/LR. Therefore, the transmit optical power P of the laser may be understood as being approximately proportional to 1/LR. In this way, under a same output power Pₒᵤₜ of the power supply, the photoelectric conversion efficiency η may be defined as a ratio of the transmit optical power P of the laser to the output power Pₒᵤₜ of the power supply, that is, η = P/Pout. Because P is approximately proportional to 1/LR, the photoelectric conversion efficiency η may be approximately proportional to 1/LR. In conclusion, reducing the parasitic inductance L and the parasitic resistance R can improve the photoelectric conversion efficiency η of the transmitting module.

However, when the quantity of packages included in the circuit structure is larger and a trace length is longer, parameter values of the parasitic inductance and the parasitic resistance introduced in the circuit structure are also larger. In the foregoing layout manner, separately packaging each component causes a large quantity of packages in the transmitting module, and the plane layout of the packages causes a winding trace on the PCB board. The large quantity of packages and the winding trace introduce a large parasitic inductance and a large parasitic resistance in the transmitting module. Consequently, the transmit optical power of the laser emitting the detection laser light is reduced. It can be learned that the foregoing layout manner reduces efficiency of converting electric energy into light energy by the transmitting module, and is not conducive to improving the photoelectric conversion efficiency of the transmitting module.

In view of this, an embodiment of this application provides an integrated apparatus, to reduce parasitics introduced in a structure of the integrated apparatus, so as to improve effective energy conversion efficiency of the integrated apparatus. For example, when the integrated apparatus integrates a laser and a capacitor in a transmitting module, the parasitics introduced in the transmitting module is reduced to improve photoelectric conversion efficiency of the transmitting module.

The following describes, by using specific embodiments, a specific implementation of the integrated apparatus provided in embodiments of this application.

FIG. 5 is a diagram of a structure of an integrated apparatus according to an embodiment of this application. The integrated apparatus includes a laser LR and a capacitor C. The laser LR includes an anode (anode), a cathode (cathode), and a first substrate. The capacitor C includes a second substrate, an insulator (insulator), and a comb-shaped first metal layer. The insulator is attached to the first metal layer. The first substrate is in contact with the second substrate, and the anode of the laser LD is embedded in the first substrate and is connected to the second substrate.

Optionally, the laser LR may be a laser diode. Optionally, the laser LR may be a laser that can emit laser light of different wavelengths. For example, the wavelength may be 905 nanometers (nm).

That the first substrate is in contact with the second substrate may mean that no other medium or device exists between the first substrate and the second substrate, and the first substrate is in direct contact with the second substrate. In an example, the first substrate and the second substrate are stacked and in contact.

A shape of the insulator may be a "bow" shape. Optionally, the insulator may be a "bow"-shaped insulator formed by depositing an insulation material on a side surface that is of the second substrate and that has a plurality of grooves after the plurality of grooves are etched on a side that is of the second substrate and that is away from the first substrate.

That the anode of the laser LD is embedded in the first substrate and is connected to the second substrate may mean that the anode is connected to the second substrate after extending in the first substrate and penetrating the first substrate. Optionally, the anode may extend to the second substrate, to be connected to the second substrate.

In the integrated apparatus provided in this embodiment of this application, the first substrate in the laser LR and the second substrate of the capacitor C are stacked and in contact, so that a distance between the laser LR and the capacitor C can be reduced in a three-dimensional layout manner. In addition, the anode of the laser LD is embedded in the first substrate and is connected to the second substrate, to implement interconnection between the laser LD and the capacitor C. In this way, no extra interconnection trace needs to be disposed between the laser LD and the capacitor, so that parasitics (for example, a parasitic inductance and a parasitic resistance) introduced in a structure of the integrated apparatus are greatly reduced, and effective energy conversion efficiency of the integrated apparatus is improved. The integrated apparatus may reduce an interconnection length between the laser LD and the capacitor C from a 100-micron (µm) level to a µm level. In addition, the comb-shaped first metal layer can further increase a specific surface area of the capacitor C, to facilitate heat dissipation and reduce a heat loss.

Optionally, the first substrate and the second substrate are integrally formed. That the first substrate and the second substrate are integrally formed herein may mean that the first substrate and the second substrate are two parts of a same substrate formed in one process, for example, may be two parts, namely, an upper part and a lower part, of a same substrate. In a possible example, the first substrate and the second substrate may be two parts, namely, an upper part and a lower part, of a same wafer (wafer). The first substrate and the second substrate are integrally formed, so that one wafer can be saved, and process materials and process costs required when two wafers are bonded (for example, bonding is implemented through back-end-of-line grinding and bonding) can also be saved.

Optionally, a material of the first substrate is the same as or different from a material of the second substrate. In a possible embodiment, the materials of the first substrate and the second substrate are the same. For example, both the materials of the first substrate and the second substrate may be aluminum gallium arsenide AlGaAs and/or gallium arsenide GaAs. In another possible embodiment, the materials of the first substrate and the second substrate are different. For example, the material of the first substrate may be AlGaAs, and the material of the second substrate may be GaAs; or the material of the first substrate may be GaAs, and the material of the second substrate may be AlGaAs. During actual application, the material of the first substrate and the material of the second substrate may alternatively be other materials. The foregoing uses only an example in which the material is AlGaAs and/or GaAs for description, and does not constitute a limitation on embodiments of this application.

Because a lattice constant of the AlGaAs is different from a lattice constant of the GaAs layer, and the lattice constant of the AlGaAs is less than the lattice constant of the GaAs layer, the AlGaAs and the GaAs undergo compressive strain in x and y directions (namely, two directions that are parallel to the substrate and perpendicular to each other), and undergo tension in a z direction (namely, a direction perpendicular to the substrate). In this way, electrons in the AlGaAs and the GaAs have a large mobility, and a corresponding resistivity is low, so that parasitic resistances of the integrated apparatus are greatly reduced, and performance of the integrated apparatus is improved. In addition, because conductivity of the AlGaAs is good, a resistance of the AlGaAs can be further reduced by using the AlGaAs, to further improve performance of the integrated apparatus.

Optionally, the cathode of the laser LD is located on a side that is of the first substrate and that is away from the second substrate. In an example, the first substrate is located above the second substrate, and the cathode is disposed on an upper surface of the first substrate. In addition, in an example, the cathode may include a plurality of sub-electrodes, and the plurality of sub-electrodes may be dispersedly distributed on the side that is of the first substrate and that is away from the second substrate.

The comb-shaped first metal layer may include a plurality of comb teeth. In a possible embodiment, distances between any two adjacent comb teeth in the plurality of comb teeth may be the same or different. In FIG. 5, an example in which distances between any two adjacent comb teeth are the same is used for description.

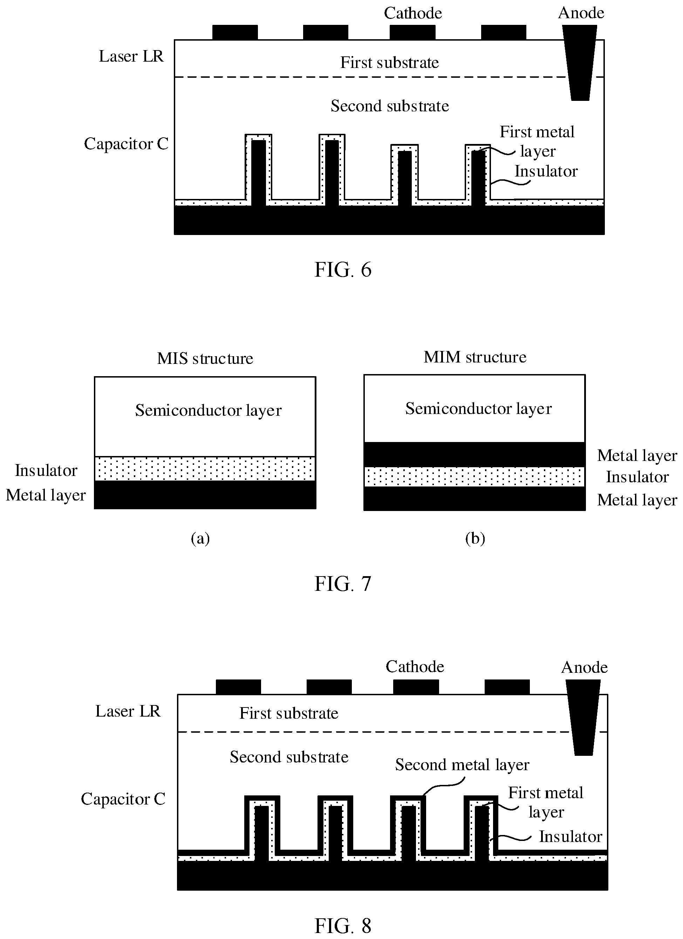

Optionally, at least two comb teeth in the first metal layer may have a same height or different heights. A height of each comb tooth herein may be a height at which the comb tooth extends into the second substrate. In an example, as shown in FIG. 5, heights of all comb teeth in the first metal layer are the same. Alternatively, in another example, as shown in FIG. 6, heights of some comb teeth in all comb teeth in the first metal layer are different from heights of other comb teeth. When comb teeth of different heights exist in the first metal layer, the comb teeth of different heights may be arranged randomly, or may be arranged in a specific order (for example, in ascending order, in descending order, or in an order in which a high comb tooth is followed by a low comb tooth, the low comb tooth is followed by another high comb tooth, the another high comb tooth is followed by another low comb tooth, and the like). This is not specifically limited in embodiments of this application.

Optionally, a highest height of the comb teeth in the first metal layer is less than a thickness of the second substrate. In other words, the comb tooth in the first metal layer does not penetrate a side surface that is of the second substrate and that is close to the first substrate.

In this embodiment of this application, as shown in (a) and (b) in FIG. 7, the capacitor C may be a capacitor of a metal-insulator-semiconductor (metal-insulator-semiconductor, MIS) structure, or may be a capacitor of a metal-insulator-metal (metal-insulator-metal, MIM) structure. When the capacitor C is of the MIS structure, the capacitor C may include the second substrate, the insulator, and the first metal layer. In this case, the second substrate may be a heavily doped substrate. For example, the second substrate is heavily doped AlGaAs or heavily doped gallium arsenide GaAs. The heavily doped substrate may also be referred to as a low-resistivity substrate. When the capacitor C is of the MIM structure, in addition to the second substrate, the insulator, and the first metal layer, the capacitor C may further include another metal layer. In this case, the second substrate may be a lightly doped or non-doped substrate, and the lightly doped or non-doped substrate may also be referred to as a high-resistivity substrate.

When the second substrate is a high-resistivity substrate, in a possible embodiment, as shown in FIG. 8, the capacitor C further includes a second metal layer, and the second metal layer is located between the second substrate and the insulator. In this case, the anode of the laser LR may be embedded in the first substrate and the second substrate, and is connected to the second metal layer. A shape of the second metal layer may also be the "bow" shape. Optionally, the second metal layer may be formed before the insulator. For example, after the plurality of grooves are etched on the side that is of the second substrate and that is away from the first substrate, a metal material may be first deposited on the side surface that is of the second substrate and that has the plurality of grooves to form the second metal layer in the "bow" shape, and then an insulation material is deposited on the second metal layer to form the insulator.

In the integrated apparatus provided in this embodiment of this application, the capacitor C with the MIS structure can be implemented by using the high-resistivity second substrate, the insulator, and the first metal layer, and the capacitor C with the MIM structure can be implemented by using the low-resistivity second substrate, the second metal layer, the insulator, and the first metal layer. Therefore, during specific implementation, flexibility and diversity of the capacitor C in the integrated apparatus can be improved.

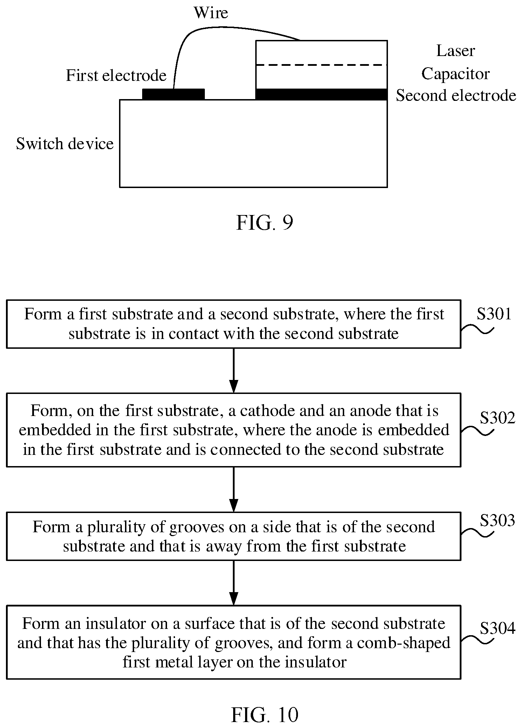

In view of this, an embodiment of this application further provides an integrated circuit. As shown in FIG. 9, the integrated circuit includes the integrated apparatus provided above and a switch device. The switch device includes a first electrode and a second electrode that are located on a same side. The integrated apparatus is disposed on the switch device. The cathode of the laser in the integrated apparatus is connected to the first electrode through a wire, and the first metal layer of the capacitor in the integrated apparatus is in contact with the second electrode. Optionally, the wire may be a bonding wire (bonding wire).

An embodiment of this application further provides a transmitting module. The transmitting module may include a power supply, a driver chip, and the integrated circuit provided above. The power supply is configured to supply power to the integrated apparatus, the driver chip is configured to send a drive signal to the integrated circuit, and the integrated circuit is configured to send detection laser light based on the drive signal.

An embodiment of this application further provides a detection apparatus. The detection apparatus may include a control circuit and the transmitting module provided above. The control circuit is configured to send a control signal to the transmitting module, and the transmitting module is configured to send detection laser light based on the control signal.

In a possible embodiment, the detection apparatus may further include a receiving module. The receiving module is configured to receive an echo signal returned after the detection laser light scans a target object, and convert the echo signal into an electrical signal. The control circuit is further configured to process the electrical signal to obtain point cloud data.

In another possible embodiment, the detection apparatus may further include a scanning module, and the scanning module is configured to perform traversal scanning on a target object by using the detection laser light.

Optionally, the detection apparatus may be a lidar, or another apparatus that can emit detection laser light. For example, some examples of the detection apparatus include but are not limited to a vehicle-mounted lidar, a laser sensor of a home robotic vacuum cleaner, a laser detection module at a dock, a laser printer, and the like.

An embodiment of this application further provides a terminal, including the detection apparatus described in the foregoing content. Optionally, the terminal includes but is not limited to: a smart home device (for example, a television, a robotic vacuum cleaner, a smart desk lamp, an acoustic system, an intelligent lighting system, an electrical control system, home background music, a home theater system, an intercom system, and a video surveillance), an intelligent transportation device (for example, a vehicle like a car, a ship, an uncrewed aerial vehicle, a train, a lorry, or a truck), an intelligent manufacturing device (for example, a robot, an industrial device, intelligent logistics, or a smart factory), or an intelligent terminal (a mobile phone, a computer, a tablet computer, a tablet computer, a desktop computer, a headset, a speaker, a wearable device, a vehicle-mounted device, a virtual reality device, an augmented reality device, and the like).

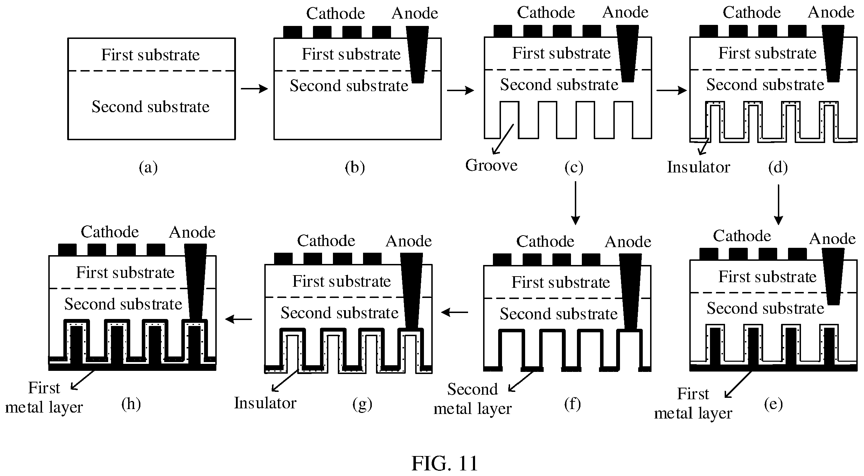

FIG. 10 is a schematic flowchart of a manufacturing method for an integrated apparatus according to an embodiment of this application. The integrated apparatus may be the integrated apparatus provided above. The method includes the following several steps. FIG. 11 is a cross-sectional view of the integrated apparatus in a manufacturing process.

S301: Form a first substrate and a second substrate, where the first substrate is in contact with the second substrate, as shown in (a) in FIG. 11.

That the first substrate is in contact with the second substrate may mean that no other medium or device exists between the first substrate and the second substrate, and the first substrate is in direct contact with the second substrate. In an example, the first substrate and the second substrate are stacked and in contact. Therefore, forming the first substrate may specifically include: forming the second substrate, and forming the first substrate on the second substrate.

Optionally, the first substrate and the second substrate are integrally formed. In a possible example, the first substrate and the second substrate may be two parts, namely, an upper part and a lower part, of a same wafer. Therefore, forming the first substrate may specifically include: forming a wafer, where the wafer includes the first substrate and the second substrate that are located in the two parts, namely, the upper part and the lower part.

Optionally, a material of the first substrate is the same as or different from a material of the second substrate. In a possible embodiment, the materials of the first substrate and the second substrate are the same. For example, both the materials of the first substrate and the second substrate may be aluminum gallium arsenide AlGaAs and/or gallium arsenide GaAs. In another possible embodiment, the materials of the first substrate and the second substrate are different. For example, the material of the first substrate may be AlGaAs, and the material of the second substrate may be GaAs; or the material of the first substrate may be GaAs, and the material of the second substrate may be AlGaAs.

S302: Form, on the first substrate, a cathode and an anode that is embedded in the first substrate, where the anode is embedded in the first substrate and is connected to the second substrate, as shown in (b) in FIG. 11.

The cathode may be located on a side that is of the first substrate and that is away from the second substrate. In an example, the first substrate is located above the second substrate, and the cathode is disposed on an upper surface of the first substrate.

In addition, that the anode is embedded in the first substrate and is connected to the second substrate may mean that the anode is connected to the second substrate after extending in the first substrate and penetrating the first substrate. Optionally, the anode may extend to the second substrate, to be connected to the second substrate.

Correspondingly, the forming, on the first substrate, a cathode and an anode that is embedded in the first substrate may specifically include: forming the cathode on the side that is of the first substrate and that is away from the second substrate, and forming the anode that is embedded in the first substrate and that is connected to the second substrate. The forming the anode that is embedded in the first substrate and that is connected to the second substrate may be specifically: forming a through hole on the first substrate and the second substrate by using a process like photoetching or etching, where the through hole is embedded in and penetrates the first substrate; and filling a metal material in the through hole by using a process like deposition, to form the anode that is embedded in the first substrate and that is connected to the second substrate.

S303: Form a plurality of grooves on a side that is of the second substrate and that is away from the first substrate. Optionally, a depth of the groove is less than a thickness of the second substrate, as shown in (c) in FIG. 11.

Distances between any two adjacent grooves in the plurality of grooves may be the same or may be different. In addition, at least two of the plurality of grooves may have a same depth or different depths. For example, depths of the plurality of grooves are the same, or depths of some of the plurality of grooves are different from a depth of another groove. In FIG. 11, an example in which distances between any two adjacent grooves are the same and depths of the plurality of grooves are the same is used for description.

In a possible embodiment, the plurality of grooves are formed, by using the process like photoetching or etching, on the side that is of the second substrate and that is away from the first substrate.

S304: Form an insulator on a surface that is of the second substrate and that has the plurality of grooves, and form a comb-shaped first metal layer on the insulator, as shown in (d) and (e) in FIG. 11.

In a possible embodiment, a "bow"-shaped insulator is formed, by using a process like deposition of an insulation material, on the surface that is of the second substrate and that has the plurality of grooves, where a thickness of the insulator is less than one half of a radial width of the groove. Then, the comb-shaped first metal layer may be formed on the insulator by using a process like deposition of a metal material, where a sum of the thickness of the insulator and a thickness of the first metal layer may be equal to the half of the radial width of the groove.

The capacitor C may be a capacitor with an MIS structure, or may be a capacitor with an MIM structure. When the capacitor C is of the MIS structure, the capacitor C may include the second substrate, the insulator, and the first metal layer. In this case, the second substrate may be a heavily doped substrate, and the heavily doped substrate may also be referred to as a low-resistivity substrate. When the capacitor C is of the MIM structure, in addition to the second substrate, the insulator, and the first metal layer, the capacitor C may further include another metal layer. In this case, the second substrate may be a lightly doped or non-doped substrate, and the lightly doped or non-doped substrate may also be referred to as a high-resistivity substrate.

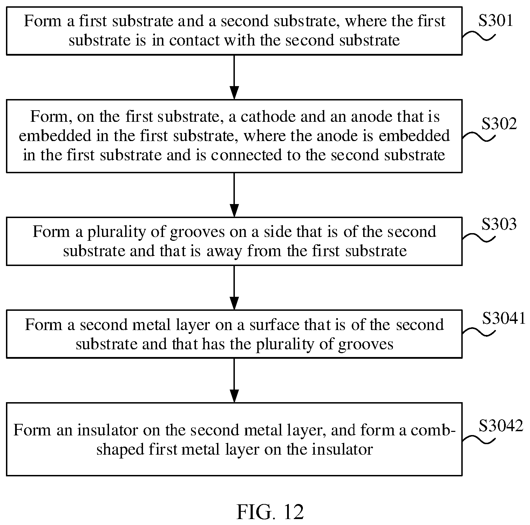

Further, the second substrate is a high-resistivity substrate, and the capacitor further includes a second metal layer. The second metal layer is located between the second substrate and the insulator, and the anode is embedded in the second substrate and is connected to the second metal layer. In this case, as shown in FIG. 12, S304 may specifically include S3041 and S3042.

S3041: Form the second metal layer on the surface that is of the second substrate and that has the plurality of grooves, as shown in (f) in FIG. 11.

In a possible embodiment, a "bow"-shaped second metal layer is formed, by using the process like deposition of a metal material, on the surface that is of the second substrate and that has the plurality of grooves, where the thickness of the second metal layer is less than the half of the radial width of the groove.

S3042: Form the insulator on the second metal layer, and form the comb-shaped first metal layer on the insulator, as shown in (g) and (h) in FIG. 11.

In a possible embodiment, the "bow"-shaped insulator is formed on the second metal layer by using the process like deposition of an insulation material, where a sum of the thickness of the insulator and the thickness of the second metal layer is less than the half of the radial width of the groove. Then, the comb-shaped first metal layer may be formed on the insulator by using the process like deposition of a metal material, where a sum of the thickness of the second metal layer, the thickness of the insulator, and the thickness of the first metal layer is equal to the half of the radial width of the groove.

In the manufacturing method for the integrated apparatus provided in this embodiment of this application, the first substrate in the laser and the second substrate of the capacitor are stacked and in contact, so that a distance between the laser and the capacitor can be reduced in a three-dimensional layout manner. In addition, the anode of the laser is embedded in the first substrate and is connected to the second substrate, to implement interconnection between the laser and the capacitor. In this way, no extra interconnection trace needs to be disposed between the laser and the capacitor, so that parasitics (for example, a parasitic inductance and a parasitic resistance) introduced in a structure of the integrated apparatus are greatly reduced, and effective energy conversion efficiency of the integrated apparatus is improved. The integrated apparatus obtained in the foregoing manufacturing method may reduce an interconnection length between the laser and the capacitor from a 100-micron (µm) level to a µm level. In addition, the comb-shaped first metal layer can further increase a specific surface area of the capacitor, to facilitate heat dissipation and reduce a heat loss.

Based on the manufacturing method provided in embodiments of this application, an embodiment of this application further provides a computer-readable storage medium. The computer-readable storage medium stores a computer program. When the computer program is run, the manufacturing method described in the foregoing content is performed.

Based on the manufacturing method provided in embodiments of this application, an embodiment of this application further provides a computer program product. When the computer program product runs on a processor, the manufacturing method described in the foregoing content is implemented.

Finally, it should be noted that the foregoing descriptions are merely specific implementations of this application, but are not intended to limit the protection scope of embodiments of this application. Any variation or replacement within the technical scope disclosed in embodiments of this application shall fall within the protection scope of embodiments of this application. Therefore, the protection scope of this application shall be subject to the protection scope of the claims.

## Claims

1. An integrated apparatus, wherein the integrated apparatus comprises:
a laser, comprising an anode, a cathode, and a first substrate; and
a capacitor, comprising a second substrate, an insulator, and a comb-shaped first metal layer, wherein the insulator is attached to the first metal layer, wherein
the first substrate is in contact with the second substrate, and the anode is embedded in the first substrate and is connected to the second substrate.

2. The integrated apparatus according to claim 1, wherein the first substrate and the second substrate are integrally formed.

3. The integrated apparatus according to claim 1 or 2, wherein a material of the first substrate is the same as or different from a material of the second substrate.

4. The integrated apparatus according to any one of claims 1 to 3, wherein the cathode is located on a side that is of the first substrate and that is away from the second substrate.

5. The integrated apparatus according to any one of claims 1 to 4, wherein the second substrate is a high-resistivity substrate, the capacitor further comprises a second metal layer, the second metal layer is located between the second substrate and the insulator, and the anode is embedded in the second substrate and is connected to the second metal layer.

6. The integrated apparatus according to any one of claims 1 to 5, wherein at least two comb teeth in the first metal layer have a same height or different heights.

7. The integrated apparatus according to claim 6, wherein a highest height of comb teeth in the first metal layer is less than a thickness of the second substrate.

8. A manufacturing method for an integrated apparatus, wherein the integrated apparatus comprises a laser and a capacitor, the laser comprises an anode, a cathode, and a first substrate, the capacitor comprises a second substrate, an insulator, and a com-shaped first metal layer, and the method comprises:
forming the first substrate and the second substrate, wherein the first substrate is in contact with the second substrate;
forming, on the first substrate, the cathode and the anode that is embedded in the first substrate, wherein the anode is embedded in the first substrate and is connected to the second substrate;
forming a plurality of grooves on a side that is of the second substrate and that is away from the first substrate; and
forming the insulator on a surface that is of the second substrate and that has the plurality of grooves, and forming the comb-shaped first metal layer on the insulator, wherein a thickness of the insulator is less than one half of a radial width of the groove.

9. The manufacturing method according to claim 8, wherein the first substrate and the second substrate are integrally formed.

10. The manufacturing method according to claim 8 or 9, wherein a material of the first substrate is the same as or different from a material of the second substrate.

11. The manufacturing method according to any one of claims 8 to 10, wherein the cathode is located on a side that is of the first substrate and that is away from the second substrate, and the forming, on the first substrate, the cathode and the anode that is embedded in the first substrate comprises:
forming the cathode on the side that is of the first substrate and that is away from the second substrate, and forming the anode that is embedded in the first substrate and that is connected to the second substrate.

12. The manufacturing method according to any one of claims 8 to 11, wherein the second substrate is a high-resistivity substrate, the capacitor further comprises a second metal layer, the second metal layer is located between the second substrate and the insulator, the anode is embedded in the second substrate and is connected to the second metal layer, and the forming the insulator on a surface that is of the second substrate and that has the plurality of grooves comprises:
forming the second metal layer on the surface that is of the second substrate and that has the plurality of grooves; and
forming the insulator on the second metal layer, wherein a sum of a thickness of the second metal layer and the thickness of the insulator is less than the half of the radial width of the groove.

13. The manufacturing method according to any one of claims 8 to 12, wherein at least two comb teeth in the first metal layer have a same height or different heights.

14. The manufacturing method according to any one of claims 8 to 13, wherein a height of a comb tooth in the first metal layer is less than a thickness of the second substrate.

15. An integrated circuit, wherein the integrated circuit comprises:
the integrated apparatus according to any one of claims 1 to 7; and
a switch device, comprising a first electrode and a second electrode that are located on a same side, wherein
the integrated apparatus is disposed on the switch device, the cathode of the laser in the integrated apparatus is connected to the first electrode through a wire, and the first metal layer of the capacitor in the integrated apparatus is in contact with the second electrode.

16. A detection apparatus, wherein the detection apparatus comprises the integrated apparatus according to any one of claims 1 to 7, or comprises the integrated circuit according to claim 15.

17. A terminal, wherein the terminal comprises the integrated apparatus according to any one of claims 1 to 7, or comprises the integrated circuit according to claim 15.

18. The terminal according to claim 17, wherein the terminal is a vehicle.
